(19) Europäisches Patentamt
European Patent Office
Office européen des brevets

(11) Publication number: **0 055 459**
**A1**

(12) # EUROPEAN PATENT APPLICATION

(21) Application number: **81110680.6**

(22) Date of filing: **22.12.81**

(51) Int. Cl.$^3$: **C 23 C 13/04**
**C 01 B 13/20**

(30) Priority: **29.12.80 JP 189561/80**
**09.09.81 JP 142012/81**

(43) Date of publication of application:
**07.07.82 Bulletin 82/27**

(84) Designated Contracting States:
**BE CH DE FR GB IT LI NL**

(71) Applicant: **Rikuun Electric co.**
**21-12, Hikawadai 3-chome**
**Nerima-ku Tokyo(JP)**

(71) Applicant: **Kamata, Kiichiro**
**1769-1, Fukasawa-machi**
**Nagaoka-shi Niigata-ken(JP)**

(72) Inventor: **Kiichiro, Kamata**
**No. 1769-1 Fukasawa-machi**
**Nagaoka-shi Niigata-ken(JP)**

(74) Representative: **Schulze Horn, Stefan, Dipl.-Ing. et al,**
**Patentanwälte Dipl.-Ing. S. Schulze Horn M.SC. Dr. H. Hoffmeister Goldstrasse 36**
**D-4400 Münster(DE)**

(54) **Process for producing oxides using chemical vapour deposition.**

(57) A process for producing oxides using chemical vapour deposition (C.V.D.) wherein simple or double oxides are obtained in film-on-substrate or fine powder form by using one kind or two kinds or more of gaseous metal β-diketone complexes in conjunction with water vapour having bonded oxygen in a quantity more than equivalent sufficient for oxidizing a metal or metals contained in said complex or complexes.

FIG. 4

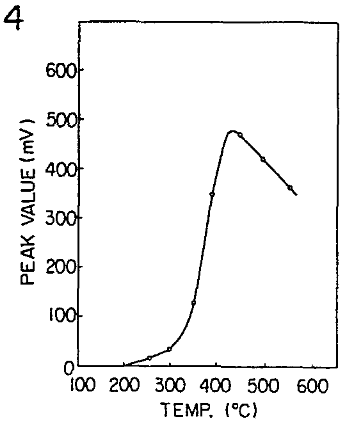


EP 0 055 459 A1

Croydon Printing Company Ltd.

# BACKGROUND OF THE INVENTION

## (a) Field of the invention

A process for producing oxides using chemical vapour deposition (C.V.D.) which comprises obtaining simple or double oxides in film-on-substrate or fine powder form by the use of one kind or two kinds or more of gaseous metal β-diketone complexes in conjunction with water vapour having bonded oxygen in quantities more than equivalent sufficient for oxidizing a metal or metals in said complex or complexes.

## (b) Description of the prior art

Chemical vapour deposition processes (C.V.D.) have been developed as the basic technique for use in semiconductor and electronics industries and also have been very publicly known as those for producing important parts of main electronic machines.

The chemical vapour deposition processes have acquired importance in not only the electronics industry but also the aniverse, atomic energy and flying machine industries as those for coating films on parts which are required to have properties sufficient to endure servere circumstances in the universe, atomic energy and flying machines such as thermal resistance, wear resistance and corrosion resistance, and also have remarkably progressed as those for coating films which are serviceable for improving the performances of high speed steels.

Oxide films to be formed by these C.V.D. processes mainly comprise single or double oxide films. When investigating the processes for forming oxide films using known C.V.D., they are found to include a number of defects as referred to afterwards, and it can not be denied that these defects have prevented the progress of the aforesaid processes. Accordingly, it can be readily contemplated therefrom that a process having eliminated

these defects, if appears, will be applied to surface treatment of general metals with thermal resisting materials and also will develope to wider range of fields.

The fact is that metal compounds used in the known oxide chemical vapour deposit processes mainly comprise metal halides, and some new trials are being made to partly use metal alkyl and metal alkoxide.

As oxidating gases there are used a mixed gas of $CO_2$ and $H_2$, water vapour and $O_2$ gas, which will be summarized in Table 1 as shown below.

Table 1 Metal oxide film forming material and reaction gas and principal reaction and application in the conventional process

| Object for oxidation | Principal product reaction | Deposition temperature °C | Application |
|---|---|---|---|
| $A\ell_2O_3$ (single crystal) | $2A\ell C\ell_3+3H_2O \rightarrow A\ell_2O_3+6HC\ell$ | 1400 - 1600 | Protecting window |
| $A\ell_2O_3$ (amorphous) | $2A\ell(CH_3)_3+9O_2 \rightarrow A\ell_2O_3+6CO_2+9H_2O$ | 350 - 500 | Surface protecting film (MOS.IC) |
| $A\ell_2O_3$ (amorphous) | $2A\ell(C_2H_5)_3+21O_2 \rightarrow A\ell_2O_3+12CO_2+15H_2O$ | 350 - 500 | Multilayered insulating film for wiring |
| " | $A\ell(i\text{-}OC_3H_7)_3 \rightarrow A\ell_2O_3+XCrHm+YH_2O$ | 350 - 450 | Surface protecting film for tool |
| " | $2A\ell C\ell_3+3CO_2+3H_2 \rightarrow A\ell_2O_3+3CO+6HC\ell$ | 800 - 950 | IC memory (MAOS) |
| " | $A\ell(O_2C_5H_7)_3 \xrightarrow{O_2} A\ell_2O_3+mH_2O+nCO_2$ | 800 - 1000 | unknown |
| $TiO_2$ (amorphous) | $TiC\ell_4+2H_2O \rightarrow TiO_2+4HC\ell$ | - 1000 | Surface protecting film |
| " | $Ti(OC_3H_7)_4+CO_2+2H_2 \rightarrow TiO_2+4HC\ell+2CO$ | 900 - 980 | Surface protecting film |
| $Ta_2O_5$ (amorphous) | $2Ta(OC_2H_5)_5 \xrightarrow{N_2+O_2} Ta_2O_5+mH_2O+nCO_2$ | 800 | Surface protecting film |
| $SnC\ell_4$ (amorphous) | $SnC\ell_4+2H_2O \rightarrow SnO_2+4HC\ell$ | 800 - 1000 | Surface protecting film |
| $Y_2O_3$ (amorphous) | Particulars of oxidating reaction caused by chelate are unknown. | 500 | Cathodluminescence |
| $TiO_2-SiO_2$ | $TiC\ell_4+SiC\ell_4+4H_2O \rightarrow TiO_2-SiO_2+8HC\ell$ | 400 - 900 | |

As shown in Table 1, the fact is that the metal compound materials for the formation of oxide films by the chemical vapour deposition process are comprised mainly of halogen compounds of high vapour pressure such as $A\ell C\ell_3$, $TiC\ell_4$ and the like, the chemical deposition reaction is generally carried out at a high temperature more than 1000°C apart from exceptions, and as the oxidating gas there is used water vapour, $H_2O$ or a mixed gas of $CO_2$ and $H_2$.

However, the conventional process using metal chloride is defective in that due to the presence of a $HC\ell$-containing corrosive gas the apparatus and substrate corrode to thereby hamper the direct deposition on the surface of various metals, the objects for film deposition are also restricted to those exhibiting anti-corrosition properties against the high temperature, humid $HC\ell$, further the oxides to which this process is applicable are restricted to $A\ell_2O_3$, $SiO_2$, $TiO_2$, $ZrO_2$ and the like wherein associated metal elements have volatile halogen compounds, and double oxides are restricted to those of $TiO_2$-$SiO_2$ system, $ZrO_2$-$SiO_2$ system and the like wherein both the associated elements have a conformably volatile halogenide.

Next, reference will be made to a process using an organic metal compound as a starting material. As such a process there is enumerated one using a metal alkyl compound. This process is advantageous in that the chemical deposition temperature is comparatively low such as 350 - 500°C as seen from the instance of $A\ell_2O_3$ in Table-1, as reaction gases there may be used $O_2$ and the like and product gases are limited to low-corrosive $CO_2$ and $H_2O$, but defective in that the metal alkyl compound used herein is extremely unstable against air and oxygen and in danger of instantly firing on contact with air, the use of the metal alkyl

compound calls for attention such as its probable violent reaction with hygroscopic moisture in the course of reaction steps and is accompanied with difficulty of preparing for the starting raw material, and it is very difficult to concurrently use the metal alkyl compound with other metal halogenides for the purpose of preparing double oxides.

In addition, there are known a process utilizing thermal cracking of a metal alkoxide compound used as an organic metal compound and a process utilizing steam as a cracked gas, but these processes are not put to practical use due to defects that the thermal cracking is hindered by deposition of carbon on the substrate and the like and in the preparation of double oxides by the concurrent use of the metal alkyl compound with halogenides the reaction conditions of both are in conformity with each other with difficulty. The same is applicable to a vapour treating process of alkoxide using water vapour as a reaction gas.

And, the unstability of alkoxide caused by contact with air is one of the significant defects, and the fact that alkoxide is relatively unstable at a practical volatile temperature of 100-200°C is also hindering the practical use of this process.
In fact, there can be found no report on the actual instance of this process having used for the production of double oxides.

## SUMMARY OF THE INVENTION

Various defects of the conventional processes in the preparation of simple oxide films and double oxide films have been discussed above. The process of the present invention to be referred to hereinafter is one capable of eliminating a number of defects inherent in aforesaid conventional processes, and solving a plurality of problems remaining unsolved in the field

where the conventional processes are now being used practically for the purpose of synthesis of simple or double oxides by virtue of chemical vapour deposition, for instance, such as the difficulty, generation of corrosive gas, height of a deposition temperature and the like, whereby the direct deposition on the metal surface can be attained almost in every case.

The process of the present invention is also one capable of facilitating the deposition of double oxides to a high degree. In other words, the process of the present invention may be said to be one providing a novel means for preparing films of double oxides of metals, Mn, Zn, Fe, Mg, Ba, etc., studies of which have been retarded because their halogenides are low volatile, such as $MnO-Fe_2O_3$ system, $MnO-ZnO-Fe_2O_3$ system, $MgO-Fe_2O_3$ system, $Y_2O_3-Fe_2O_3$ system, $Fu_2O_3-Fe_2O_3$ system, $BaO-TiO_2$ system, $Y_2O_3-ZrO_2$ system, and the like, and further contributing largely to the development of the range of application of chemical deposition process.

It is another object of the present invention to provide a process for preparing a thin-film sensor by using chemical vapour deposition.

It is considered that the conventional processes for forming oxide films by means of chemical vapour deposition are characterized in that every deposition reaction is carried out basically in the manner of extending the reaction caused in normal temperature liquid phase even into high temperature gaseous phase as seen in the reaction of $A\ell C\ell_3$ with water and the reaction of alkoxide with water respectively, and have studied and determined the conditions for chemical deposition in the gaseous phase.

Much of metal β-diketone complexes is stable on contact with water at normal temperatures. Probably due to this, study has

scarcely been made on the reaction of metal β-diketone complex with a reaction gas, i.e. water vapour. Rather, study has been made mainly on the oxidating reaction using oxygen at a temperature of 800 - 1000°C. However, it has been proved from the inventor's study results that the oxidation by oxygen is poor in reproducibility and the chemical vapour deposition at a temperature of 80 - 800°C, preferably 350 - 800°C as expected by the inventor can in no way be attained. In view of this, the inventor has carried out fundamental studies on the reactions of β-diketone complex with various gases.

As the result of having carried out chemical vapour deposition by using β-diketone complex and gases such as oxygen, air, $CO_2$, $H_2$, $N_2$, water vapour, argon and the like, the inventor has confirmed that the reaction by oxygen does form no thin film and rather is harmful to the thin film formation, and further has ascertained that steam is the most effective reaction gas.

The inventor has made collective investigations on the reactivity of both metal β-diketone complex and water vapour with both carried in an inert carrier gas for the purpose of obtaining a process capable of achieving a stable chemical deposition at a relatively low temperature of 80 - 800°C, preferably 350 - 800°C on the basis of the above obtained results. Needless to say, the present invention permits to attain said stable chemical deposition at higher temperatures.

First, the inventor has investigated the synthesis of β-diketone complexes of heavy metal elements such as Aℓ, Ti, Mg, Ba, Zr, Zn, Mn, Fe, Y, Eu and the like to confirm that the synthesis of metal β-diketone complexes which are of volatility usable for chemical vapour deposition at a temperature less than 280°C can be attained in any case and that when a mixture,

obtained by mixing an inert carrier gas carried β-diketone complex therein with water vapour to such an extent that the ratio of bonded oxygen contained in the water vapour to metal atoms contained in β-diketone may be more than equivalent to form an oxide on which chemical vapour deposition is made, is contacted with a heated substrate on which a film is formed, the corresponding oxide deposits almost in a fixed quantity. In addition thereto, the inventor has confirmed that the deposition of oxide fine powder can be obtained by allowing said mixture to pass through a heated electric tubular furnace in place of contacting it with the heated substrate.

The present invention provides a process for producing oxides using chemical vapour deposition which comprises forming an oxide film on a substrate by mixing one kind or two kinds or more of gaseous metal β-diketone complexes with water vapour having bonded oxygen in a quantity more than equivalent sufficient for oxidizing a metal or metals contained in said complex or complexes, with both carried in a carrier gas, and contacting the resulting mixed gas with said heated substrate.

The present invention also provides a process for producing oxides using chemical vapour deposition which comprises forming oxide fine powder by mixing one kind or two kinds or more of gaseous metal β-diketone complexes with water vapour having bonded oxygen in a quantity more than equivalent sufficient for oxidizing a metal or metals contained in said complex or complexes, with both carried in a carrier gas, and passing the resulting mixed gas through a heated electric tubular furnace.

Said heating temperatures ordinarily may be 80°C or more, preferably 350°C or more.

Particulars of the reaction mechanism between water and

β-diketone complex are not confirmed clearly yet. However, there is no possibility of the apparatus and substrate being corroded because the metal β-diketone complex once forms a hydrate which decomposes on the surface of the substrate into metal oxide, $CO_2$, hydrogen and hydrocarbon and, when the mixing ratio of water vapour is great, mainly into $CO_2$ and $H_2$.

Furthermore, a double oxide having a desired molar ratio can readily be obtained by mixing another metal β-diketone complex with an inert carrier gas so as to have a predetermined molar ratio and reacting the resulting mixture with water vapour in accordance with the abovementioned standard.

Still further, it has been confirmed that when the molar ratio of a highly volatile metal halide to metal β-diketone complex whose halogen compound is too low in volatility to be used in chemical vapour deposition is set to a predetermined ratio in the presence of a required carrier gas and both metals are reacted with water vapour, a double oxide, which has not been fully studied upto now, can be prepared in the film or fine powder form at a low temperature of 80 - 800°C, preferably 350 to 800°C, and in a fixed quantity by means of chemical vapour deposition.

As is evident from the aforegoing, the present invention should be said directed toward a process capable of eliminating the defects inherent in the conventional C.V.D. processes and exhibiting various superior characteristics. Although the process of the present invention is considered to have a wide application range, explanation will be made on one instance where said process is applied to the production of a thin-film sensor.

The fact is that printing and sputtering processes have been employed widely for the purpose of producing sensors by using thick-film or thin-film oxide semiconductors. However, both

processes are defective. In more detail, the former comprises complicated steps and the latter is unsuitable for mass production.

First of all, taking into consideration the thermistor manufacturing process as one instance of the printing process publicly known as the process for the production of thick-film sensors, it is found that the manufacturing process comprises a step for preparing thermistor powders, a step for preparing a thermistor paste and a printing step and is not simple. The preparation of thermistor powders comprises a series of steps of mixing, calcination, pulverizing, forming, baking and pulverizing of the raw material powder. Next, $RuO_2$ or glass first is mixed with said thermistor powder, and then an organic vehicle is added to the resulting mixture and mingled, whereby there can be obtained a thermistor paste. Further, the thermistor paste and electrodes are printed on a substrate, and the same is baked at a high temperature of about 800°C, thereby completing a thick-film thermistor. In the case of the printing process described above, however, there is fixed the limitation in pulverizing the oxide sensor, thereby narrowing the scope of utility of the sensor, and at the same time the divergent, complicated manufacturing steps bring about increased manufacturing costs.

In this process, furthermore, there is no denying the presence of difficulties from the quality management that the steps of mixing, calination, etc. each exerts a delicate influence upon the characteristic of the final product thermistor.

On the other hand, the thermistor manufacturing process utilizing the sputtering process also includes a heavy defect that since it is operated under vacuum, it is accompanied with large-sized equipments and increased installation costs and at the same time it is unsuitable for mass production.

According to our process for producing oxide films utilizing chemical vapour deposition makes it possible to produce various oxide thin films containing a wide range of oxides, which could never be produced by the conventional chemical vapour deposition process, readily by deposition at a relatively low temperature, and further to produce various sensors, including thermistor, by the combination of thus obtained oxide thin films and electrodes and by the steps simplified extremely as compared with those of the conventional printing process and the like.

The process according to the present invention may include one comprising forming an oxide thin film by applying a mixed gas of complex gas and water vapour onto a substrate, on which electrodes have previously been printed and heat-treated, through a suitable-shaped nozzle or one comprising depositing an oxide thin film and then forming electrodes thereon.

The present invention dispenses with all the pre-treatment operations such as preparation of oxide fine powders and the like as described above with reference to the thick-film sensor manufacturing process and permits the formation of an oxide thin-film on a substrate by mixing complex gases during the transport and reacting it with water vapour in situ. Due to this, the present invention makes it possible to obtain a thin-film sensor with a fine and uniform structure readily through a very few operations and further to mass-produce the thin-film sensors readily because they may be prepared under atmospheric conditions.

As the β-diketone complexes used in the present invention there can be enumerated those having the general formula (I):

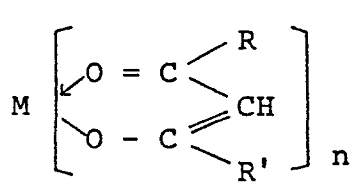

..... (I)

(wherein M is a metal, and n is equal to the number of valences of a metal. R and R' are $-CH_3$, $-CF_3$, $-C_4H_9$, $-C_4H_3S$ or $-C_4H_3O$.)

Hereinafter there will be enumerated concrete examples of β-diketone compounds (bracketed degrees are volatile temperatures).

(1) Acetylacetone complex

| | | | |
|---|---|---|---|
| $Ca(C_5H_7O_2)_2$ | (270°C), | $Mg(C_5H_7O_2)_2$ | (240°C), |
| $Cd(C_5H_7O_2)_2$ | (240°C), | $Zr(C_5H_7O_2)_4$ | (150°C), |
| $V(C_5H_7O_2)_3$ | (160°C), | $Cr(C_5H_7O_2)_3$ | (150°C), |
| $Rh(C_5H_7O_2)_3$ | (160°C), | $Ni(C_5H_7O_2)_2$ | (160°C), |
| $Pt(C_5H_7O_2)_2$ | (150°C), | $Cu(C_5H_7O_2)_2$ | (150°C), |
| $Th(C_5H_7O_2)_4$ | (160°C), | $Mn(C_5H_7O_2)_2$ | (150°C), |
| $Fe(C_5H_7O_2)_3$ | (150°C), | $Co(C_5H_7O_2)_2$ | (150°C), |
| $Pd(C_5H_7O_2)_2$ | (150°C), | $Hg(C_5H_7O_2)_2$ | (130°C), |
| $Ga(C_5H_7O_2)_3$ | (150°C), | $In(C_5H_7O_2)_3$ | (150°C), |
| $Al(C_5H_7O_2)_3$ | (160°C), | $Zn(C_5H_7O_2)_2$ | (100°C), |
| $Be(C_5H_7O_2)_3$ | (90°C), | $Sc(C_5H_7O_2)_3$ | (200°C), |
| $U(C_5H_7O_2)_4$ | (200°C), | $Ti(C_5H_7O_2)_4$ | (140°C), |
| $Hf(C_5H_7O_2)_4$ | (200°C), | | |

(2) Dipivaloylmethane complex (DPM) = $(C_{11}H_{19}O_2)$

DPM = 2,2,6,6-tetramethyl-3,5-keptanedione

| | | | |
|---|---|---|---|
| $La(DPM)_3$ | (200°C), | $Ce(DPM)_3$ | (190°C), |
| $Pr(DPM)_3$ | (190°C), | $Nd(DPM)_3$ | (190°C), |
| $Sm(DPM)_3$ | (190°C), | $Eu(DPM)_3$ | (190°C), |
| $Gd(DPM)_3$ | (200°C), | $Tb(DPM)_3$ | (170°C), |
| $Dy(DPM)_3$ | (170°C), | $Ho(DPM)_3$ | (160°C), |
| $Er(DPM)_3$ | (160°C), | $Tm(DPM)_3$ | (160°C), |
| $Yb(DPM)_3$ | (160°C), | $Lu(DPM)_3$ | (160°C), |
| $Sc(DPM)_3$ | (140°C), | $Y(DPM)_3$ | (160°C), |
| $Th(DPM)_4$ | (180°C), | $Zr(DPM)_4$ | (180°C), |

$Ti(DPM)_4$ (180°C), $Sn(DPM)_4$ (190°C),

$Hf(DPM)_4$ (180°C),

(3) Hexafluoroacetylacetone complex

(HFAA) = ($CF_3COCHCOCF_3$)

$Ba(HFAA)_2$ (220°C), $La(HFAA)_3$ (170°C),

$Th(HFAA)_4$ (170°C), $Zr(HFAA)_4$ (200°C),

$Hf(HFAA)_4$ (200°C),

(4) Trifluoroacetylacetone complex

(TFA) = ($CF_3COCHCOCH_3$)

$Ce(TFA)_3$ (140°C), $Th(TFA)_4$ (140°C),

$Mg(TFA)_2$ (170°C), $Ba(TFA)_2$ (240°C),

$Ga(TFA)_3$ (140°C), $Zr(TFA)_4$ (150°C),

(5) Tenoyltrifluoroacetone complex

(TTA) = ($C_8H_4O_2F_3S$)

$Pd(TTA)_2$ (220°C), $Ba(TTA)_2$ (200°C),

$Pb(TTA)_2$ (220°C), $U(TTA)_4$ (240°C),

$Cd(TTA)_2$ (250°C),

(6) Furoyltrifluoroacetone complex

(FTA) = ($C_8H_4O_3F_3$)

$Pd(FTA)_2$ (210°C), $Ba(FTA)_2$ (190°C),

$Pb(FTA)_2$ (210°C).

The representative preparation examples of β-diketone complex according to the present invention will be given as follows:

Process for synthesizing $Fe(C_5H_7O_2)_3$[tris(acetylacetonato) iron(III)]0.05 mol (20.2 g) of $Fe(NO_3)_3$ is dissolved in water. $NH_4OH$ is added to the resulting solution slowly to precipitate hydroxide. The solution is thus neutralized.

Thereafter, 0.15 mol (15.5 mℓ) of acetylacetone is added to the thus treated solution and the same is reflexed for

30 minutes.

The solution is cooled, filtered and washed with hot water to remove unreacted acetylacetone.

Finally, it is dried in a vacuum desicator.

Synthesis of $Y(C_{11}H_{19}O_2)_3$

0.06 mol of dipivaloylmethane is dissolved in 30 mℓ of ethanole, and put in a thick flask with a stop cock connected to an exhaust unit.

Next, 2.4 gr of NaOH is dissolved in 50 mℓ of 50% ethanole, and the resulting solution is poured in the flask.

The reaction product is stirred continuously by means of a magnetic stirrer.

To this is further added a solution obtained by dissolving 0.02 mol of $Y(NO_3)_3 \cdot 6H_2O$ in 50 mℓ of 50% ethanole.

Immediately, the flask is vacuumized, sealed and stirred for 2 hours.

Then, it is distilled under reduced pressure until the quantity of the solution is reduced to half of its initial quantity.

And, 350 mℓ of a distilled water is added thereto to thereby separate a precipitate.

The separated $Y(C_{11}H_{19}O_2)_3$ is vacuum-filtered promptly and dried.

The obtained crystals are re-crystallized in vacuum from n-hexane, and further vacuum-dried. (m.p. = 177 - 180°C).

## BRIEF DESCRIPTION OF THE DRAWING

Fig. 1 is a cross-sectional view of the double-tube nozzle used in the present invention.

Figs. 2 and 3 are X-ray diffraction views of the ZnO film

obtained by the present invention and commercially available ZnO powder respectively.

Fig. 4 is a graph illustrating the relationship between temperature and sensitivity of the ZnO thin-film sensor prepared in accordance with the present invention.

Fig. 5 is a graph illustrating the relationship between resistance and oxygen partial pressure of the CoO thin-film sensor prepared in accordance with the present invention.

Fig. 6 is a graph illustrating the relationship between temperature and resistance of the NiO-$Li_2O$ thin-film sensor prepared in accordance with the present invention.

Fig. 7 is a perspective view of the thin-film gas sensor prepared in accordance with the present invention.

## DESCRIPTION OF THE PREFERRED EMBODIMENTS

Example 1

A nitrogen gas containing 3% of a tris(acetylacetonato) aluminum[$Al(C_5H_7O_2)_3$]gas is fed at the speed of current of 180 mℓ/sec in the direction of the arrow 11 as indicated in Fig. 1 into a Pyrex-made or stainless steel-made double-tube nozzle 13 heated by means of a heater 12.

On the other hand, a nitrogen gas containing 15% of a water vapour gas is fed at the speed of current of 540 mℓ/sec in the direction of the arrow 14 into the double-tube nozzle 13.

The mol ratio of complex gas to water vapour gas is 1:15.

Two kinds of gases mixed in the nozzle were applied onto a Si substrate (2 cm x 2 cm) heated to 350°C.

The speed of separation was 8300 Å/min.

The properties of the resulting alumina film are as shown in Table 2.

Table 2

| Product | Alumina ($A\ell_2O_3$) |
|---|---|
| Temperature of substrate | 350°C |
| Structure observed by X-ray | Amorphous |
| Grain diameter | 0.5 μ or less |
| Thickness of film | 25 μ |

The gas produced by the reaction did not corrode the Si substrate at all, thereby producing superior alumina films alone.

And, the amorphous alumina films were heat-treated at 1000°C for 2 hours in an Ar gas, and consequently the amorphous alumina was converted into α-alumina.

In this instance, the distance between the nozzle and the substrate is 1.5 cm.

Example 2

A nitrogen gas containing 2% of a gas obtained by sublimating bis(acetylacetonato)magnesium(II) [$Mg(C_5H_7O_2)_2$] is fed to a nozzle at the speed of current of 180 mℓ/min.

On the other hand, a nitrogen gas containing 10% of a water vapour gas is fed to the same nozzle at the speed of current of 300 mℓ/min.

The mol ratio of complex gas to water vapour gas in this instance is 1 : 8.3.

The gas mixed in the nozzle was applied onto a Si substrate (2 cm x 2 cm).

The properties of the obtained film are as shown in Table-3.

Table 3

| Product | Magunesia (MgO) |
|---|---|
| Temperature of substrate | 350°C |
| Crystal structure | Rock salt structure |
| Grain diameter | 0.5 μ or less |
| Thickness of film | 3.6 μ |

Example 3

A nitrogen gas containing 3% of a bis(acetylacetonato)zinc (II) [$Zn(C_5H_7O_2)_2$] gas is fed to a nozzle at the speed of current of 180 mℓ/sec.

On the other hand, a nitrogen gas containing 10% of a water vapour gas is fed to the same nozzle at the speed of current of 600 mℓ/sec.

The mol ratio of complex gas to water vapour gas is 1 : 11.

The gas mixed in the nozzle was applied onto a Si substrate (2 cm x 2 cm).

The separating speed was 7500 Å/min when the temperature of substrate was 500°C.

The properties of the thus formed film are as shown in Table 4.

Table 4

| Product | ZnO |
|---|---|
| Temperature of substrate | 500°C |
| Crystal structure | Hexagonal system |
| Grain diameter | 0.3 μ or less |
| Thickness of film | 20 μ |

It was observed from the X-ray diffraction figure shown in Fig. 2 that the thus formed ZnO film was strongly directional in the direction of C axis.

In Fig. 2 there was shown X-ray diffraction figure of the ZnO film obtained by the present invention and in Fig. 3 there was shown X-ray diffraction figure of the commercially available ZnO powder.

Example 4

A nitrogen gas containing 2% of a gas obtained by sublimating bis(acetylacetonato)manganese(II), $Mn(C_5H_7O_2)_2$ is fed at the speed of current of 90 mℓ/min and on the other hand a nitrogen gas containing 2% of a gas obtained by sublimating tris(acetylaceto-nato)iron(III) is fed at the speed of current of 180 mℓ/min respectively. Both complex gases are mixed and fed to a nozzle. On the other hand, a nitrogen gas containing 40% of a water vapour gas is fed to the same nozzle at the speed of current of 300 mℓ/min. The mol ratio between the bis(acetylacetonato) manganese(II), tris(acetylacetonato)iron(III) and water vapour gas is 1 : 2 : 67.

The gas mixed in the nozzle was applied onto a Si substrate (2 cm x 2 cm).

The distance between the tip of the nozzle and the substrate is 1.5 cm.

The separating speed of the film was 4200 Å/min when the temperature of substrate was 800°C.

The properties of the thus obtained film are as shown in Table 5.

Table 5

| | |
|---|---|
| Product | $MnFe_2O_4$ |
| Temperature of substrate | 800°C |
| Crystal structure | Spinnel structure |
| Grain diameter | 0.5 μ or less |
| Thickness of film | 10.5 μ |

Example 5

An argon gas containing 3% of a gas obtained by sublimating tetrakis(acetylacetonato)zirconium (IV), $Zr(C_5H_7O_2)_4$, is fed at the speed of current of 180 mℓ/min and in addition an argon gas containing 1% of a tris(diprivaloylmethane)yttrium(III) [$Y(C_{11}H_{19}O_2)_3$]gas is fed at the speed of current of 90 mℓ/min. Both are mixed and fed to a nozzle.

On the other hand, an argon gas containing 30% of a water vapour gas is fed to the nozzle at the speed of current of 480 mℓ/min.

The mol ratio between the tetrakis(acetylacetonato)zirconium (IV), tris(dipivaloylmethane)yttrium(III) and water vapour gas is 1 : 0.17 : 27.

The complex gases and steam gas were mixed in the nozzle. The obtained mixed gas was applied onto a Si substrate heated to 800°C.

The properties of the yttria-containing zirconia thus produced are as shown in Table 6.

Table 6

| Product | Yttria-containing zirconia |
|---|---|
| Temperature of substrate | 800°C |
| Crystal structure | Cubic system |
| Grain diameter | 0.3 μ or less |
| Thickness of film | 28 μ |

The separating speed of the film was 5800 Å/min in this instance.

Example 6

An Ar gas containing 3% of a $TiCl_4$ gas is fed at the speed of current of 120 mℓ/min and in addition an Ar gas containing 3% of a bis(thenoyltrifluoroacetomato)lead(II)[$Pb(TTA)_2$]gas is fed at the speed of current of 120 mℓ/min. Both gases are mixed and fed in a nozzle.

On the other hand, an argon gas containing 30% of a water vapour gas is fed to the nozzle at the speed of current of 480 mℓ/min.

The mol ratio between the $TiCl_4$, $Pb(TTA)_2$ and water vapour gas is 1 : 1 : 40.

The gas mixed in the nozzle was applied onto a Si substrate (2 cm x 2 cm).

The properties of the thus produced $PbTiO_3$ are as shown in Table 7.

Table 7

| | |
|---|---|
| Product | $PbTiO_3$ |
| Temperature of substrate | 800°C |
| Crystal structure | Perovskite structure |
| Grain diameter | 0.3 μ or less |
| Thickness of film | 34 μ |

The separating speed of the film in this instance was 5500 Å/min.

Example 7

An Ar gas containing 3% of a bis(acetylacetonato)calcium(II) $[Ca(C_5H_7O_2)_2]$gas is fed at the speed of current of 120 mℓ/min and an Ar gas containing 3% of a titanium alkoxide$[Ti(OC_3H_7)_4]$gas is fed at the speed of current of 120 mℓ/min. Both gases are mixed and fed to a nozzle.

On the other hand, an Ar gas containing 30% of a water vapour gas is fed to the nozzle at the speed of current of 480 mℓ/min, too.

The mol ratio therebetween is 1 : 1 : 40.

The gas mixed in the nozzle was applied onto a Si substrate (2 cm x 2 cm) heated to 800°C.

The separating speed of the film in this instance was 6200 Å/min.

The properties of the thus produced $CaTiO_3$ are as shown in Table 8.

Table 8

| Product | $CaTiO_3$ |
|---|---|
| Temperature of substrate | 800°C |
| Crystal structure | Perovskite structure |
| Grain diameter | 0.5 μ or less |
| Thickness of film | 30 μ |

Example 8

An argon gas containing 3% of a tris(dipivaloylmethane)europium(III)[$Eu(DPM)_3$]gas is fed at the speed of current of 120 mℓ/min, and an argon gas containing 3% of a tris(acetylacetonato) iron(III) is fed at the speed of current of 200 mℓ/min. And, these gases are mixed. This mixed gas was fed in an electric tubular furnace (800°C) whose core tube had the inside diameter of 30 mmϕ together with an argon gas containing 10% of a water vapour gas fed at the speed of current of 500 mℓ/min.

The mol ratio therebetween is 3 : 5 : 42.

The properties of $Eu_3Fe_5O_{12}$ garnet fine power collected from the inside of the core tube of the electric tubular furnace are as shown in Table 9.

Table 9

| Product | $Eu_3Fe_5O_{12}$ garnet |
|---|---|
| Baking temperature | 800°C |
| Crystal system | Hexagonal system |
| Particle diameter | 0.3 μ or less |

Example 9

A nitrogen gas containing about 3% of a bis(acetylacetonato) zinc(II)[$Zn(C_5H_7O_2)_2$]gas is fed to a stainless steel-made double tube nozzle at the speed of current of 180 mℓ/min.

At the same time, a nitrogen gas containing 40% of a water vapour gas is fed to the nozzle at the speed of current of 600 mℓ/min.

The mol ratio of the complex gas to the water vapour gas is 1 : 44.

The gas mixed in the nozzle was applied onto a comb platinum electrode-printed alumina substrate (1 cm x 1.5 cm).

In this instance, the temperature of the substrate is 500°C and the separating time is 15 minutes.

The thus produced ZnO thin-film sensor was measured in the presence of 0.1% of propane gas by means of a typical current detecting method (current source voltage = 2V and load resistance = 1 KΩ).

The measured results are as shown in Fig. 4.

Example 10

A nitrogen gas containing about 2% of a gas obtained by sublimating bis(acetylacetonato)cobalt(II), $Co(C_5H_7O_2)_2$, is fed to a nozzle at the speed of current of 180 mℓ/min.

At the same time, a nitrogen gas containing about 40% of a water vapour gas is fed to the same nozzle at the speed of current of 300 mℓ/min.

The mol ratio of the complex gas to the water vapour gas is 1 : 33 in this instance.

The gas mixed in the nozzle was applied onto a comb platinum electrode-printed alumina substrate (1 cm x 1.5 cm).

In this case, the temperature of the substrate was 500°C,

and the separating time was 20 minutes.

The relationship between resistance and oxygen partial pressure of the thus produced CoO thin-film sensor at 1000°C was as illustrated in Fig. 5.

Example 11

A nitrogen gas containing about 3% of a gas obtained by sublimating bis(acetylacetonato)nickel(II), $Ni(C_5H_7O_2)_2$, is fed at the speed of current of 180 mℓ/min, and a nitrogen gas containing about 3% of a gas obtained by sublimating bis(acetylacetonato)lithium(I), $Li(C_5H_7O_2)_2$, is fed at the speed of current of 60 mℓ/min. Both gases are mixed and fed to a nozzle.

At the same time, a nitrogen gas containing about 40% of a water vapour gas is fed to the same nozzle at the speed of current of 600 mℓ/min.

The mol ratio between the complex gases and water vapour gas is 3 : 1 : 133.

The gas mixed in the nozzle was applied onto a comb silver electrode-printed alumina substrate (1 cm x 1.5 cm).

In this instance, the temperature of the substrate was 500°C, and the separating time was 30 minutes.

The relationship between temperature T and resistance of the thus produced $NiO-Li_2O$ thin-film sensor was as shown in Fig. 6.

Example 12

An oxide thin-film gas sensor was prepared by chemical vapour depositing a tin oxide thin film as a gas sensor on one face of an alumina substrate (1 cm x 1.5 cm x 0.8 mm thick) and a ruthenium oxide thin as a heater on another face of said substrate respectively and then providing a parallel platinum electrode on either face.

First, a nitrogen gas containing about 3% of a tin

isopropoxide $Sn(OC_3H_7)_4$ gas is fed at the speed of current of 180 mℓ/min and a nitrogen gas containing about 2% of a tetrakis(acetyl-acetonato)thorium(IV) $[Th(C_5H_7O_2)_4]$gas is fed at the speed of current of 30 mℓ/min. These gases are mixed and fed to a nozzle.

At the same time, a nitrogen gas containing about 40% of a water vapour gas is fed to the same nozzle at the speed of current of 600 mℓ/min.

The gas mixed in the nozzle was applied onto the surface of an alumina substrate, thereby forming a thoria-containing tin oxide thin film.

Subsequently, a ruthernium oxide thin film was formed on the other surface of said alumina substrate by using an ruthenium isopropoxide $[Ru(OC_3H_7)_4]$gas with a water vapour gas in accordance with the same procedure as mentioned above.

Further, a parallel comb platinum electrode was printed onto each of the oxide thin films formed on both sides of the substrate, thereby preparing a thin-film gas sensor.

The structure of the thus prepared sensor was as illustrated in Fig. 7.

WHAT IS CLAIMED IS:

- 1 -

A process for producing oxides using chemical vapour deposition which comprises forming an oxide film on a substrate by mixing one kind or two kinds or more of gaseous metal β-diketone complexes with water vapour having bonded oxygen in a quantity more than equivalent sufficient for oxidizing a metal or metals contained in said complex or complexes, with both carried in a carrier gas, and contacting the resulting mixed gas with said heated substrate.

- 2 -

A process for producing oxides using chemical vapour deposition which comprises forming oxide fine powder by mixing one kind or two kinds or more of gaseous metal β-diketone complexes with water vapour having bonded oxygen in a quantity more than equivalent sufficient for oxidizing a metal or metals contained in said complex or complexes, with both carried in a carrier gas, and passing the resulting mixed gas through a heated electric tubular furnace.

- 3 -

A process according to Claim 1 or Claim 2 wherein said metal β-diketone complex is represented by the general formula (I),

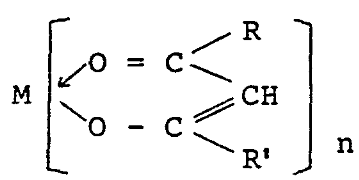 ..... (I)

(wherein M is a metal, and n is equal to the number of valences of the metal. R and R' are $-CH_3$, $-CF_3$, $-C_4H_9$,

$-C_4H_3S$ or $-C_4H_3O$.)

- 4 -

A process according to Claim 1 or Claim 2 wherein said metal β-diketone complex is metal acetylacetone complex, metal dipivaloylmethane complex, metal hexafluoroacetylacetone complex, metal trifluoroacetylacetone complex, metal thenoyltrifluoroacetone complex or metal furoyltrifluoroacetone complex.

- 5 -

A process according to Claim 1 or Claim 2 wherein said metal β-diketone complex is tris(acetylacetonato)aluminum(III), bis(acetylactonato)magnesium(II), bis(acetylacetonato)zinc(II), bis(acetylacetonato)manganese(II), tetrakis(acetylacetonato)zirconium(IV), tris(dipivaloylmethane)yttrium(III), bis(themoyltrifluoroacetonato)lead(II), bis(acetylacetonato)calcium(II), tris(dipivaloylmethane)europium(III), tris(acetylacetonato)iron(III), bis(acetylacetonato)cobalt(II), bis(acetylacetonato)nickel(II), bis(acetylacetonato)lithium(I) or tetrakis(acetylacetonato)thorium(IV).

- 6 -

A process according to any preceding claim wherein said heating temperature is not less than 80°C.

- 7 -

A process according to Claim 6 wherein said heating temperature is not less than 350°C.

A process according to Claim 7 wherein said heating temperature is in a range of 80 - 350°C.

FIG. 1

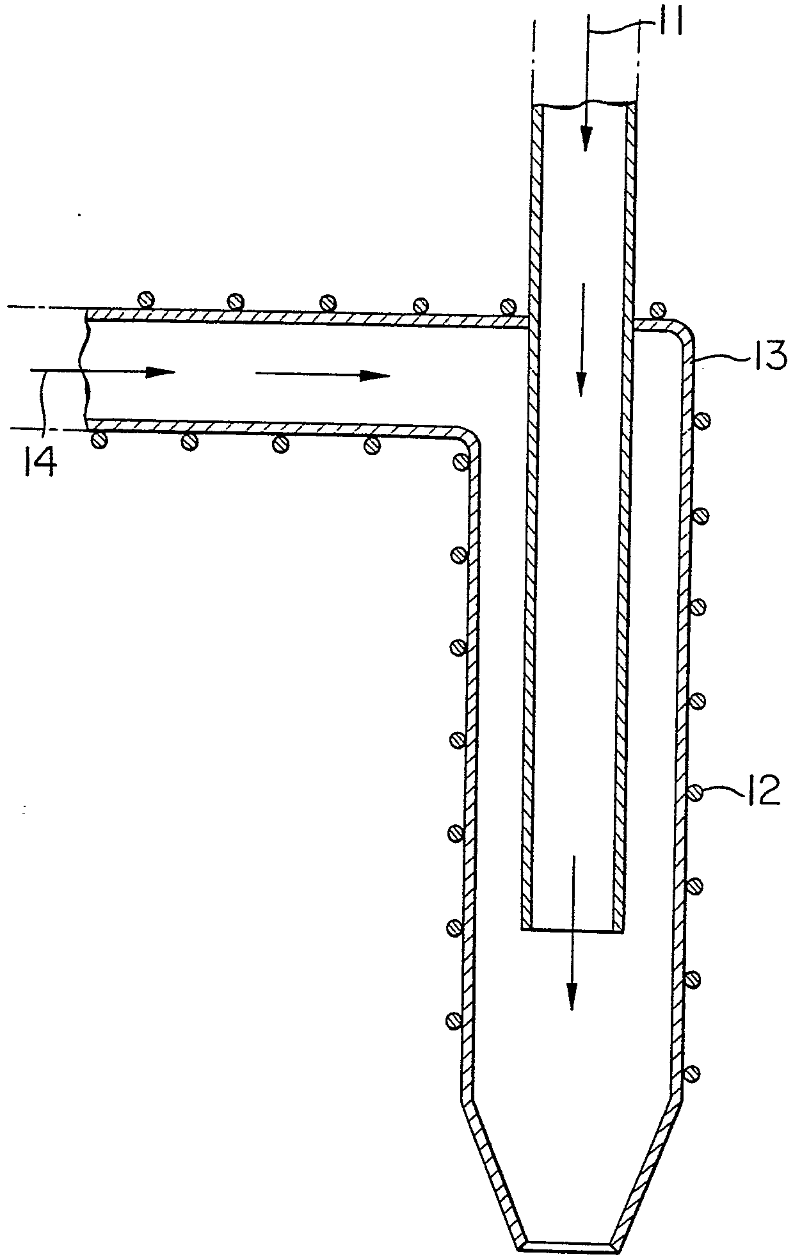

FIG. 2

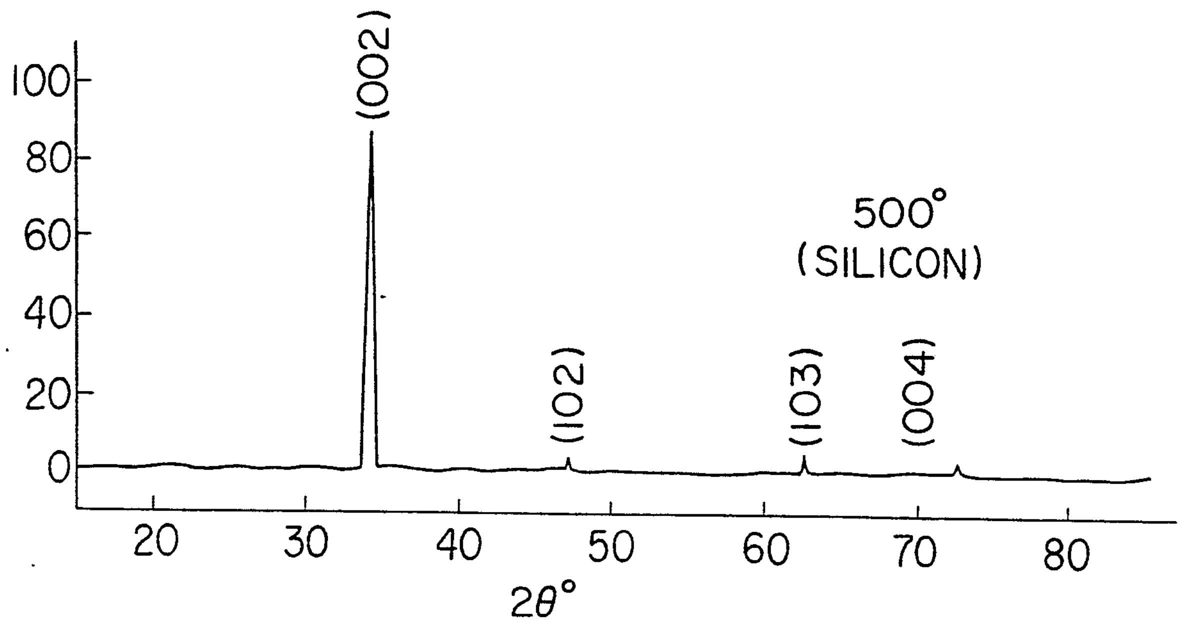
100
80
60
40
20
0
(002)
500°
(SILICON)
(102)
(103)
(004)
20
30
40
50
60
70
80
2θ°

FIG. 3

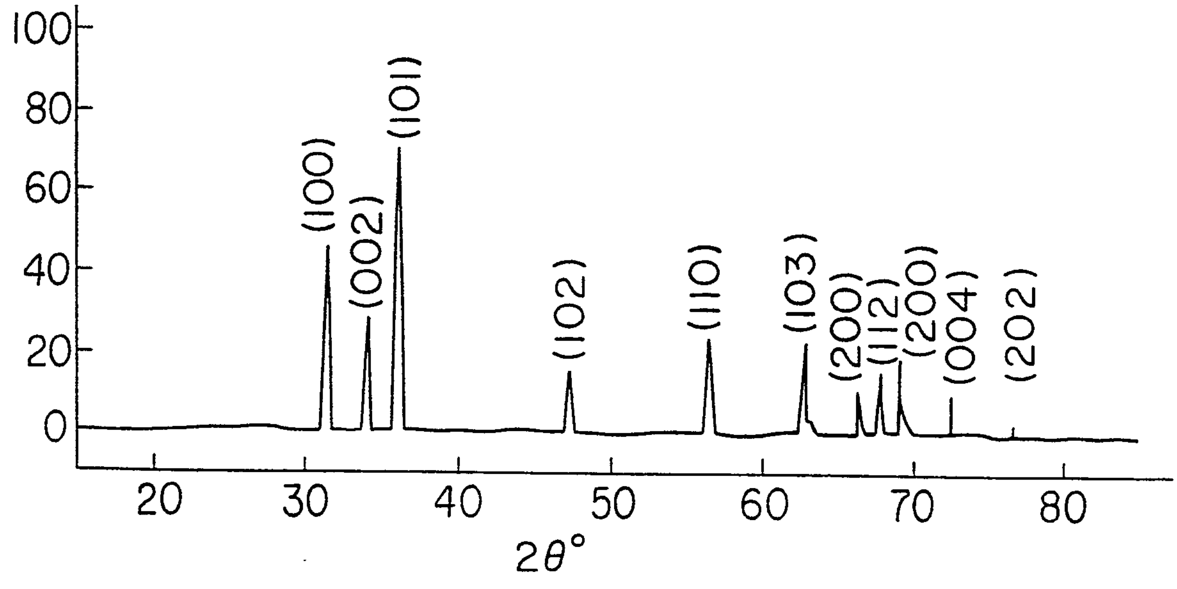
100
80
60
40
20
0
(100)
(002)
(101)
(102)
(110)
(103)
(200)
(112)
(200)
(004)
(202)
20
30
40
50
60
70
80
2θ°

FIG. 4

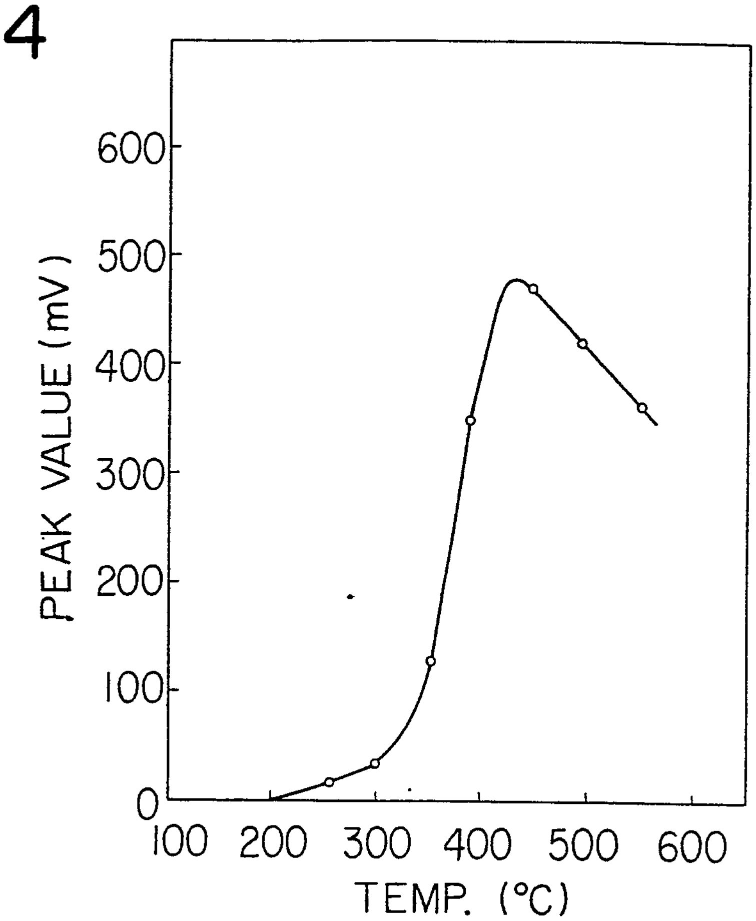
600
500
400
300
200
100
0
PEAK VALUE (mV)
100
200
300
400
500
600
TEMP. (°C)

FIG. 5

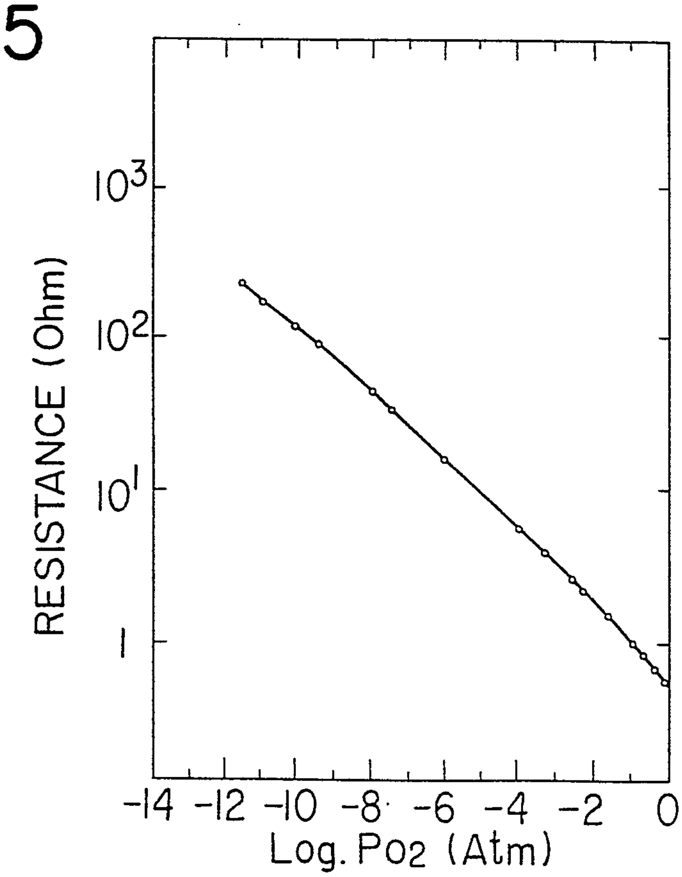
$10^3$
$10^2$
$10^1$
1
RESISTANCE (Ohm)
-14
-12
-10
-8
-6
-4
-2
0
Log. Po2 (Atm)

FIG. 6

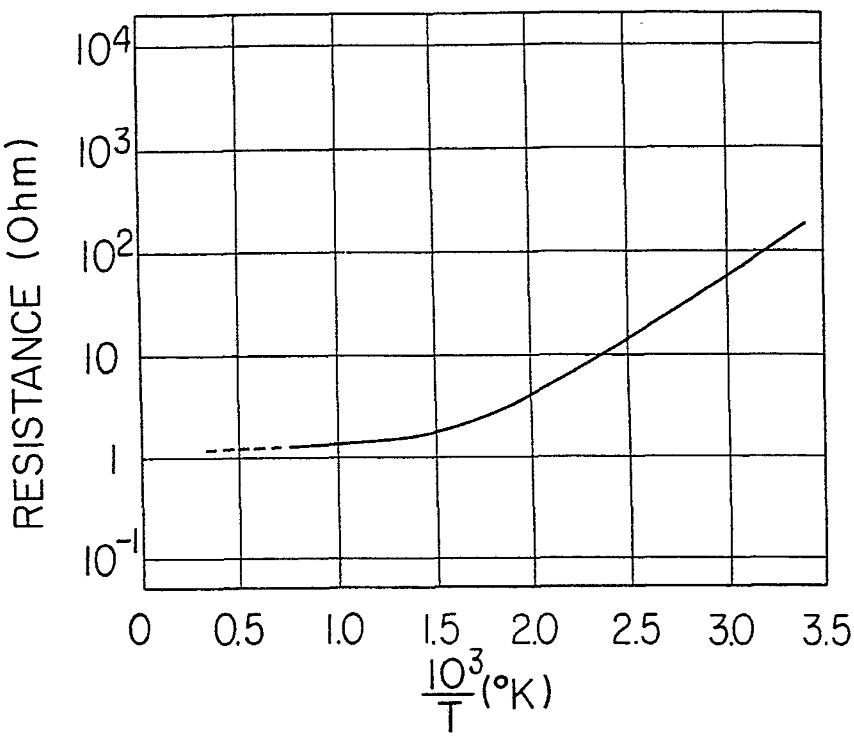
RESISTANCE (Ohm)
$10^4$
$10^3$
$10^2$
10
1
$10^{-1}$
0
0.5
1.0
1.5
2.0
2.5
3.0
3.5
$\frac{10^3}{T}$ (°K)

FIG. 7

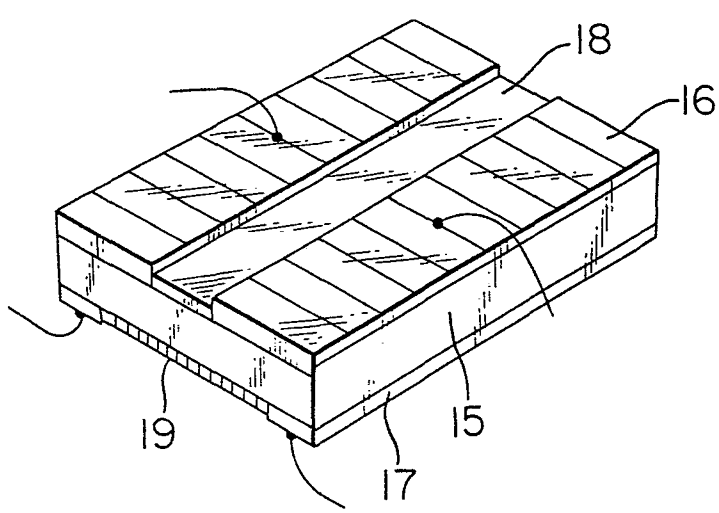
18
16
19
15
17

0055459

European Patent Office

# EUROPEAN SEARCH REPORT

Application number

EP 81 11 0680.6

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| P,X | EP - A1 - 0 022 349 (BRITISH PETROLEUM)<br>* claims 1, 5 to 7, 13 *<br>-- | 1-8 | C 23 C 13/04<br>C 01 B 13/20 |
| X | Chemical Abstract vol. 83, no. 6, 11 August 1975<br>Columbus, Ohio, USA<br>C.J. VIGUIE et al. "Chemical vapor deposition at low temperatures"<br>page 76, column 2, abstract no. 44785c<br>& J. Electrochem. Soc. vol. 122, no. 4, 1975, pages 585 to 588<br>-- | 1-7 | |
| X | JOURNAL OF ELECTROCHEMICAL SOCIETY, Vol. 127, No. 8, August 1980<br>Manchester, USA<br>CHI KWAN LAU et al. "Growth of Epitaxial ZnO Thin Films by Organometallic Chemical Vapor Deposition"<br>pages 1843 to 1847<br>* page 1844, left column, paragraph 1 *<br>-- | 1-5 | TECHNICAL FIELDS SEARCHED (Int.Cl. 3)<br>C 01 B 13/00<br>C 01 G 1/00<br>C 23 C 13/00 |
| A | Chemical Abstract vol. 89, no. 16, 1978, Columbus, Ohio, USA<br>R.E. SIEVERS et al. "Volatile metal complexes", page 133, column 2, abstract no. 131739h<br>& Science vol. 201, no. 4352, 1978, pages 217 to 223<br>---- | | |

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

X The present search report has been drawn up for all claims

| Place of search | Date of completion of the search | Examiner |
|---|---|---|
| Berlin | 24-03-1982 | KESTEN |